## Europäisches Patentamt
## European Patent Office
## Office européen des brevets

(19)

(11) Veröffentlichungsnummer: **0 013 707 B1**

(12) **EUROPÄISCHE PATENTSCHRIFT**

(45) Veröffentlichungstag der Patentschrift:
27.10.82

(51) Int. Cl.³: **H 01 L 23/48**

(21) Anmeldenummer: 79104649.3

(22) Anmeldetag: 22.11.79

(54) Leistungs-Halbleiterbauelement.

(30) Priorität: 22.12.78 DE 2855493

(43) Veröffentlichungstag der Anmeldung:
06.08.80 Patentblatt 80/16

(45) Bekanntmachung des Hinweises auf die Patenterteilung:
27.10.82 Patentblatt 82/43

(84) Benannte Vertragsstaaten:
AT BE CH FR GB IT NL SE

(56) Entgegenhaltungen:
DE-A-1 514 149
DE-A-2 910 959
DE-B-1 141 029
DE-U-6 806 029
Patents Abstracts of Japan Band 3, Nr. 61, 26. Mai 1979, Seite 92 E 113
Patents Abstracts of Japan Band 1, Nr. 155, 12. Dezember 1977, Seite 8317 E 77

(73) Patentinhaber: BROWN, BOVERI & CIE Aktiengesellschaft Mannheim, Kallstadter Strasse 1, D-6800 Mannheim Käfertal (DE)

(72) Erfinder: Jester, Alfred, Dipl.-Ing., Friedrich-Hölderlin-Weg 7, D-6720 Speyer (DE)
Erfinder: Müller, Elmar, Dipl.-Ing., Rodensteiner Strasse 40, D-6908 Alzey (DE)
Erfinder: Holick, Hubert, Dipl.-Ing., Planckstrasse 10, D-6840 Lampertheim (DE)

(74) Vertreter: Kempe, Wolfgang, Dr. et al, c/o Brown, Boveri & Cie AG Postfach 351, D-6800 Mannheim 1 (DE)

**0 013 707**

Leistungs-Halbleiterbauelement

Die Erfindung bezieht sich auf ein Leistungs-Halbleiterbauelement mit einem Gehäuse, in dem eine mindestens einen pn-Übergang aufweisende Halbleiterscheibe über einen aus einem bürstenähnlichen Bündel von verdrillten Einzeldrähten bestehenden Metallkontakt mit einer Kupferscheibe, die zur Wärmeableitung und zur Stromzuführung dient, stoffschlüssig verbunden ist.

Ein derartiges Leistungs-Halbleiterbauelement ist bekannt aus der Druckschrift »Patent Abstracts of Japan«, Vol. 1, No. 155, 12. Dez. 1977, Seite 8317E77, JP-A-52-97 673. Es umfaßt eine in einem Gehäuse angeordnete Halbleiterscheibe mit mindestens einem pn-Übergang, welche mit ihrer Unterseite hart auf eine Metallscheibe aufgelötet ist. Die Oberseite der Halbleiterscheibe sowie die Unterseite der Metallscheibe sind über je ein Bündel aus verdrillten Kupferdrähten mit Kühlkörpern aus Kupfer verbunden. Das Halbleiterbauelement erhält seine volle elektrische Funktionsfähigkeit durch das Anpressen der Kühlkörper mit einem Druck von 50 bis 100 kg/cm$^2$. Die Verbindung zwischen der Halbleiterscheibe und den äußeren Kontakten ist eine gemischte Löt- und Druckkontaktierung. Einzelheiten hinsichtlich der Beschaffenheit oder Länge der Einzeldrähte und der Lotverbindung sind dieser Druckschrift nicht zu entnehmen.

Aus der DE-B-1 141 029 ist eine Halbleiteranordnung bekannt, bei der eine Elektrodenplatte eines Halbleiterbauelements flächenhaft mit einem metallischen Bauteil verbunden ist, welches zur Abführung der Verlustwärme bestimmt ist und einen anderen thermischen Ausdehnungskoeffizienten hat als die Elektrodenplatte. Zu diesem Zweck ist zwischen der Elektrodenplatte und dem wärmeabführenden Bauteil eine im Verhältnis zu ihrem Durchmesser dünne Ausgleichsplatte angeordnet, die mosaikartig aus einer Vielzahl metallischer Einzelkörper zusammengesetzt ist. Bei diesen Einzelkörpern handelt es sich bevorzugt um Kupferstifte, deren Länge sich zu ihrem Durchmesser mindestens etwa wie 2 : 1 verhält. Um ein Einlaufen des Lotes zwischen die Kupferstifte zu verhindern, sind die Mantelflächen der Stifte mit einer nicht lötbaren Schicht überzogen, z. B. oxidiert. Die Stifte werden von einem Ring zusammengehalten. Dieser Ring darf weder mit der Elektrodenplatte noch mit dem wärmeabführenden Bauteil verlötet werden. Ferner soll das Material des Ringes einen höheren thermischen Ausdehnungskoeffizienten haben als das Material der Stifte. Infolge dieser Eigenschaften kann sich der Ring, der im kalten Zustand einen Druck auf die eingeschlossenen Stifte ausübt, bei Erwärmung der Anordnung auf Betriebstemperatur lockern. Bei Raumtemperatur steht das Bauelement unter mechanischer Spannung und nur bei Betriebstemperatur können die Stifte frei gegeneinander arbeiten. Da die bekannte Ausgleichsplatte zwischen zwei massiven Metallteilen — einerseits eine Molybdänscheibe, andererseits eine Kupferscheibe — angeordnet ist, sind durch die in den Kupferstiften entstehenden mechanischen Spannungen keine Zerstörungen an diesen Teilen zu erwarten. Das Ausgleichselement verschlechtert lediglich die thermische und elektrische Leitfähigkeit. Im übrigen zeigt die moderne Druckkontakttechnik bei Leistungshalbleitern, daß zwischen Kupferkühlkörper und Molybdänscheibe ein Ausgleichselement zum Abfangen der unterschiedlichen thermischen Ausdehnungskoeffizienten nicht erforderlich ist (vgl. VDE-Buchreihe, Bd. 11, (1966), Seite 84). .

Aus der DE-A-1 514 149 ist eine weitgehend lötfreie Kontaktierung für die Stromzuleitungen zu einer Halbleiterscheibe mit dem Ziel eines möglichst kleinen Übergangswiderstandes bekannt. Zu diesem Zweck wird auf die Halbleiterscheibe je ein Multikontaktkissen, das aus einem feindrähtigen, filzartigen Metallpreßling besteht, aufgelegt. Da Siliziumscheibe und Kupferkontaktkissen sich beim Erwärmen unterschiedlich stark ausdehnen, müssen die äußeren Drähte des Multikontaktkissens auf der Oberfläche der Siliziumscheibe rutschen sobald der Durchmesser der Siliziumscheibe eine bestimmte Größe überschreitet. Dadurch wird die Oberseite der Halbleiterscheibe mechanisch abgerieben, so daß nach einer gewissen Zahl von Wärmewechseln das Bauelement ausfällt.

Aus der GB-B-876 133 ist ein Halbleiterbauelement bekannt, bei dem Kontakt zwischen Siliziumscheibe und Kupferscheibe durch ein spiralig aufgewickeltes, längsgeschlitztes und im Bereich der Längsschlitze ausgebauchtes Kupferband gebildet wird. Die Kupferspirale wird an ihrem oberen und unteren Ende jeweils durch eine aufgesetzte und angelötete Metallkappe zusammengehalten. Diese Kappe wird über eine Zwischenelektrode mit der Halbleiterscheibe verlötet. Die Schwierigkeiten, die beim Verlöten von Metallscheiben mit der Halbleiterscheibe auftreten, sind bereits eingangs erläutert worden. Das bekannte Kontaktelement ermöglicht lediglich einen Ausgleich von axialen Wärmeausdehnungsdifferenzen.

In dem DE-GM-6 806 029 wird der Kontakt zwischen Halbleiterscheibe und äußeren Anschlüssen durch Litzendrähte gebildet. Diese Litzendrähte sind an ihren beiden Enden mit je einem Quetschschuh versehen. Der Quetschschuh ist an die Halbleiterscheibe bzw. an den äußeren Anschluß gelötet. Im Zwischenbereich ist die Litze aufgefächert, um einem Kühlmittel eine größere Wärme abführende Oberfläche darzubieten. Auch mit derartigen Litzendrähten können nur relativ kleinflächige Halbleiterelemente kontaktiert werden, da sonst die durch die unterschiedliche Wärmeausdehnung von Halbleitermaterial und Kupfer bzw. Lot die bekannten Probleme auftreten.

Der vorliegenden Erfindung liegt die Aufgabe zugrunde, eine Kontaktierung für großflächige Leistungs-Halbleiterbauelemente zu schaffen, die einen elektrisch und mechanisch verbesserten

2

Kontakt zwischen Halbleiterscheibe und den äußeren Wärmeableiterscheiben ermöglicht und die unterschiedlichen Wärmeausdehnungskoeffizienten von Halbleitermaterial und Kupfer auszugleichen ermöglicht

Diese Aufgabe wird dadurch gelöst, daß jeder Einzeldraht so mit einer Gleitschicht überzogen ist, daß die Einzeldrähte sich untereinander nicht stoffschlüssig verbinden, daß die Einzeldrähte mit zunehmendem Abstand von der Mittellinie des Bündels zunehmend länger sind als es dem Abstand zwischen Halbleiterscheibe und Kupferscheibe entspricht und daß jeder Einzeldraht unmittelbar mit der Halbleiterscheibe stoffschlüssig verbunden ist.

Durch diese Maßnahme wird vorteilhaft erreicht, daß die Einzeldrähte einer radialen Wärmedehnung folgen können und dennoch die einander zugekehrten Flächen von Halbleiterscheibe und Wärmeableiterscheibe parallel bleiben. Anstelle der bei der Druckkontakttechnik üblichen Molybdän-Ronde wird also ein in radialer Richtung elastischer Metallkontak verwendet, der sowohl mit der Halbleiterscheibe als auch mit der Wärmeableitscheibe großflächig stoffschlüssig und dennoch stabil verbunden werden kann, weil die auf die Halbleiterscheibe wirkenden Zuspannungen reduziert sind. Geeignete Verbindungsverfahren sind Löten, Schweißen oder Diffusionsbonden. Die ansonsten bei großflächiger Lötung an der Halbleiterscheibe auftretenden Zugspannungen werden eheblich reduziert, weil den einzelnen Drähten eine mit zunehmendem Abstand von der Mittellinie zunehmende Längenvorgabe gegeben ist. Mit anderen Worten: Die unterschiedliche Radialwärmeausdehnung zwischen der Halbleiterscheibe und den Wärmeableitscheiben wird auf eine weitgehend kräftefreie Drehbewegung zwischen diesen beiden zurückgeführt.

Vorzugsweise ist die Halbleiterscheibe beidseitig über je ein Bündel mit je einer Kupferscheibe verbunden, wobei die beiden Bündel vorteilhafterweise mit einander entgegengesetztem Drehsinn vorverdrillt sind. Durch diese entgegengesetzte Verdrillung wird erreicht, daß die radialen Ausdehnungsunterschiede zwischen den Ableitscheiben und der Halbleiterscheibe in eine Drehung der Halbleiterscheibe selbst um die Mittellinie umgesetzt werden. Die beiden Ableitscheiben sind nicht hinsichtlich einer gegenseitigen Verdrehung beansprucht, so daß äußere Kühlkörper, z. B. Wärmerohre, Kühldosen, wasserführende Stromschienen, problemlos anschließbar sind und die beiden Wärmeableitscheiben in herkömmlicher Technik mit dem um den Scheibenrand der Halbleiterscheibe umlaufenden Isoliergehäuse verbunden werden können.

Zweckmäßig weisen die Bündel eine Verdrillung von etwa 2 Umdrehungen auf 1 m Länge auf, bezogen auf ein noch nicht quer zu seiner Längsachse zerteiltes Paralleldrahtbündel.

Vorzugsweise besteht jedes Bündel aus Unterbündeln, die ebenfalls in sich vorverdrillt sind. Damit wird vorteilhaft eine Längenvorgabe erreicht, die ein Nachgeben bei einem ungleichmäßigen Temperaturprofil über dem Radius der Halbleiterscheibe, insbesondere bei maximaler Temperatur in der Mitte, erlaubt. D. h., die Längenvorgabe kann bezüglich des Abstandes von der Mittellinie zum Rand des Metallbündelkontaktes hin nach einer beliebigen Funktion eingestellt werden.

Die einzelnen Drähte sind zweckmäßig mit einer Gleitschicht aus Kohlenstoff, eloxiertem Aluminium oder Emaille überzogen.

Alternativ dazu können auch die Zwischenräume zwischen den Einzeldrähten durch eine hochelastische Füllmasse, vorzugsweise aus Silikonkautschuk, in Schaumform ausgefüllt sein.

Sowohl die Gleitschicht als auch die Füllmasse ermöglichen eine hohe Packungsdichte des Bündels bei Aufrechterhaltung der weitgehend freien Beweglichkeit der Drähte gegeneinander. Dabei ist anzumerken, daß bei der erfindungsgemäßen Technik eine Packungsdichte oberhalb 50% Drahtmaterial bereits vorteilhaft gegenüber einer vollen Metallronde ist, weil das Bündel einen absolut gleichmäßigen stoffschlüssigen Kontakt mit der Halbleiterscheibe über die gesamte Scheibenoberfläche hinweg erlaubt.

Die Erfindung wird nachfolgend anhand eines in der Zeichnung dargestellten Ausführungsbeispiels näher erläutert. Es zeigt

Fig. 1 eine Halbleiterscheibe, die beidseitig über Einzeldrähte gleicher Länge mit Wärmeableitscheiben verlötet ist,

Fig. 2a einen Ausschnitt aus Fig. 1 vor dem Löten,

Fig. 2b einen Ausschnitt aus Fig. 1 nach dem Löten,

Fig. 3 ein Diagramm, aus dem die temperaturbedingten Ausdehnungsdifferenzen von Silizium und Kupfer entnehmbar sind,

Fig. 4 die Schubspannung an der Halbleiterscheibe gemäß Fig. 1 in Abhängigkeit vom Scheibenradius, ohne Verdrillung der Drähte,

Fig. 5 die Zugspannung an der Halbleiterscheibe nach Fig. 1 in Abhängigkeit vom Scheibenradius,

Fig. 6 ein Dehnungsdiagramm zu Fig. 1,

Fig. 7 eine perspektivische Ansicht eines vorverdrillten Metallbündelkontaktes mit der Darstellung der Längenvorgabe entsprechend dem Verdrehwinkel,

Fig. 8 eine Halbleiterdiode im Schnitt mit Kontaktierung über gegensinnig verdrillte Metallbündelkontakte, die in der Darstellung nicht geschnitten sind.

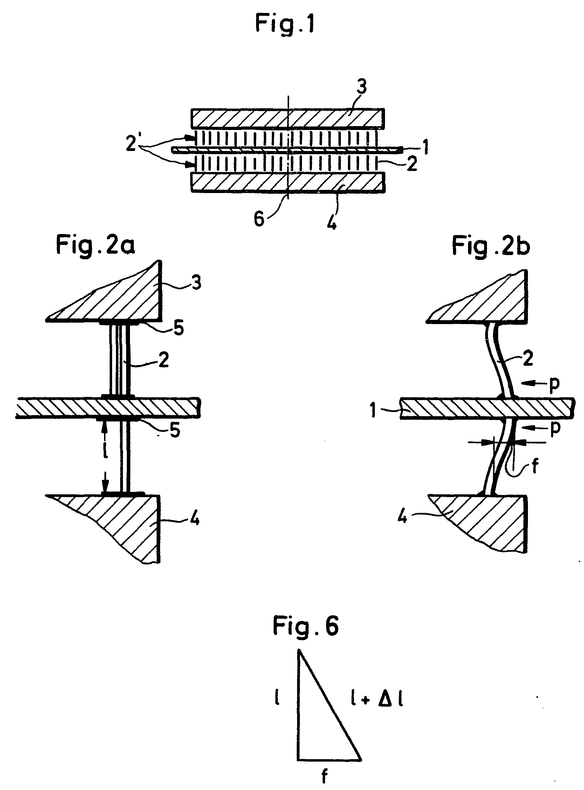

Zum besseren Verständnis sei zunächst von einer Anordnung gemäß Fig. 1 ausgegangen, bei der eine Siliziumscheibe 1 über zwei unverdrillte Metallbündelkontakte 2' von Einzeldrähten 2 aus Kupfer mit Wärmeableitscheiben 3 und 4 aus Kupfer verlötet ist. Die Einzeldrähte 2 besitzen eine gleiche Länge 1 und einen Durchmesser d (Fig. 2). Sie sind über stoffschlüssige Verbindungen 5, z. B. Lotverbindungen, sowohl mit der Siliziumscheibe 1 als auch jeweils mit der entsprechenden Wärmeableitscheibe 3, 4 verbunden.

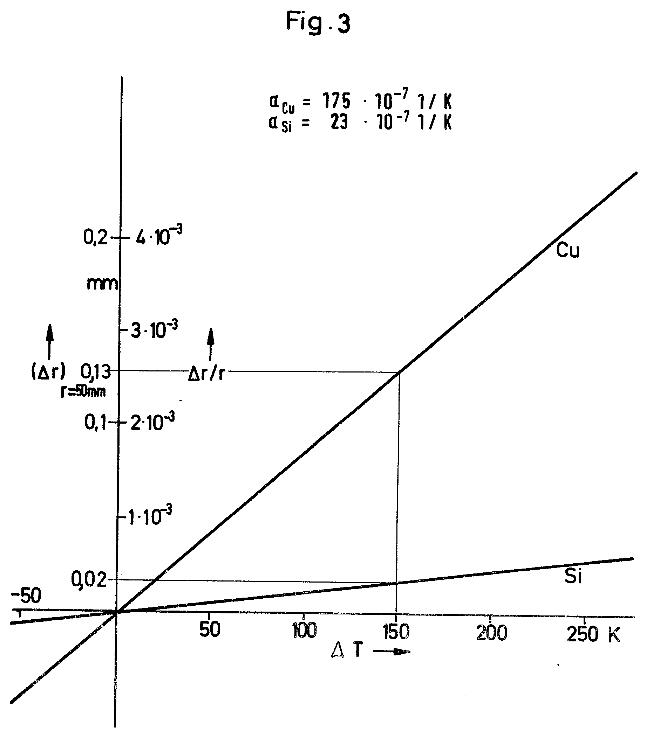

In Fig. 3 erkennt man ein rechtwinkliges Koordinatensystem, auf dessen Abszisse die Temperaturdifferenz $\Delta T$ in Kelvin und auf dessen Ordinate auf der rechten Skala die relative Vergrößerung $\Delta r/r$ einer Scheibe mit dem Radius r und auf dessen linker Seite die absolute Längenänderung $\Delta r$ in Millimeter für eine Scheibe mit dem Radius r = 50 mm aufgetragen sind. Man erkennt, daß bei der als Beispiel eingetragenen Temperaturerhöhung $\Delta T$ = 150K eine Siliziumscheibe ihren Radius um 0,02 mm, eine gleich große Kupferscheibe ihren Radius um 0,13 mm vergrößert. Die Radiusdifferenz von 0,11 mm muß von dem Verbindungsglied zwischen Kupferscheibe und Siliziumscheibe aufgenommen werden, ohne daß dabei eines der beteiligten Elemente mechanisch zerstört oder der elektrische und thermische Übergang behindert wird.

Nachfolgend werden die bei dieser Art der Kontaktierung an der Siliziumscheibe 1 auftretenden Zug- und Schubspannungen abgeschätzt:

Die unterschiedliche radiale Wärmedehnung zwischen Wärmeableitscheibe 3 bzw. 4 und Siliziumscheibe 1 hat zur Folge, daß die Bündel 2' nach dem Erstarren des Lotes beim Abkühlen auf Raumtemperatur in der in Fig. 2b gezeichneten Weise verformt werden. Die zur Auslenkung f erforderliche Kraft P ergibt sich zu

(1) $\quad P = \dfrac{E \cdot J}{l^3} \cdot 12\,f \quad$ wobei

$\quad E = $ Elastizitätsmodul des Bürstenmaterials

$\quad J = \dfrac{\pi}{64} \cdot d^4 = $ Flächenträgheitsmoment eines Drahtes mit Durchmesser d

$\quad l = $ Länge eines Bündeldrahtes

(2) $\quad f = r \cdot \Delta \alpha \cdot \Delta T \qquad T = $ unterschiedliche radikale thermische Ausdehnung zwischen Metall- und Siliziumscheibe mit

$\qquad r = $ Abstand von der Mittellinie

$\qquad \Delta \alpha = $ Differenz der Ausdehnungskoeffizienten

$\qquad \Delta T = $ Differenz zwischen Löt- und Raumtemperatur

Bei dichter Packung der einzelnen Drähte 2 resultiert hieraus an der Siliziumscheibe 1 eine Schubspannung

(3) $\quad \tau = \dfrac{P}{d^2 \cdot \pi/4} = \dfrac{3 \cdot E \cdot d^2 \cdot f}{4 \cdot l^3}$

(2) in (3) eingesetzt ergibt sich:

(4) $\quad \tau = \dfrac{3 \cdot E \cdot d^2 \cdot \Delta \alpha \cdot \Delta T}{4 \cdot l^3} \cdot r$

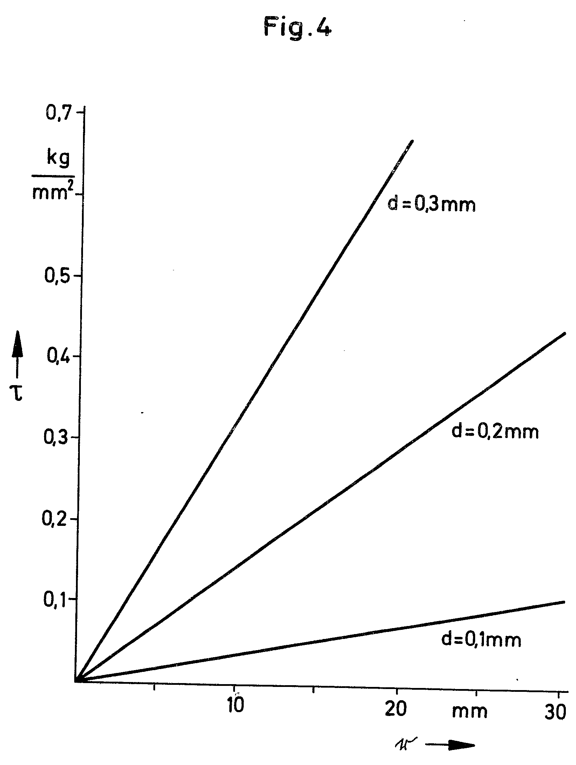

Die Schubspannungen $\tau$ an der Siliziumscheibe 1 sind in Fig. 4 für verschiedene Drahtdurchmesser d aufgetragen. Als Material für die Wärmeableitscheibe 3 bzw. 4 und die Bürsten- bzw. Bündeldrähte 2 wird von der Anwendung und den Kosten her mögliches bzw. wünschenswertes Kupfer angenommen. Von der Leitfähigkeit her ist natürlich Silber als Drahtmaterial günstiger.

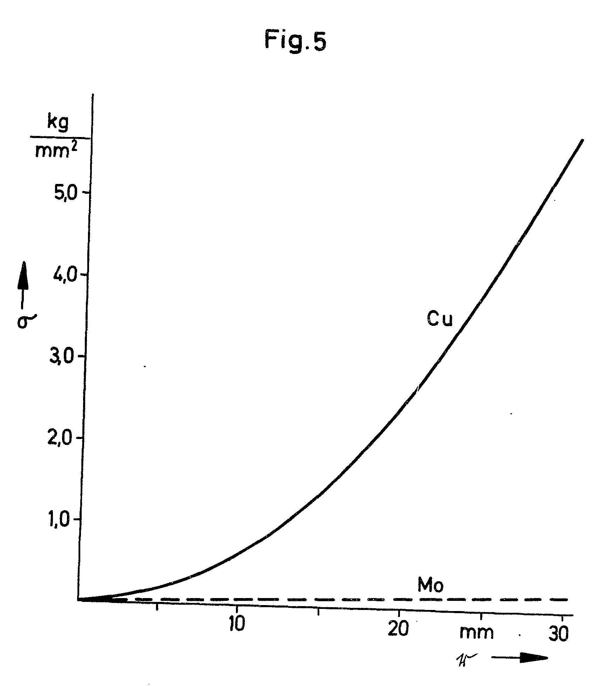

Außer der radialen Versetzung f erfahren die Drähte 2 eine Längung $\Delta l$ bei Annahme unendlich steifer Wärmeableitscheiben. Die an der Siliziumscheibe 1 angreifende Zugspannung $\sigma$ ergibt sich zu (Fig. 5):

(5) $\quad \sigma = E \cdot \dfrac{\Delta l}{l}$

$\qquad = E \left( \sqrt{1 + \left( \dfrac{r \cdot \Delta \alpha \cdot \Delta T}{l} \right)^2} - 1 \right)$

Man erkennt, daß diese Zugspannung unabhängig vom Durchmesser d der einzelnen Drähte 2 ist. Würde man anstelle der Kupferscheibe 3 bzw. 4 eine solche aus Molybdän einsetzen, so ergäbe sich ein wesentlich niedrigere an der Siliziumscheibe angreifende Zugspannung (Fig. 5, gestrichelte Kurve). Damit hätte man jedoch die Probleme der Wärmeausdehnung lediglich von der Si-Scheibe 1 weg nach außen hin verlagert, denn der Kühlkörper, an den die Wärme abzuführen ist, besteht üblicherweise aus Kupfer oder einem ähnlichen Material mit großem thermischem Ausdehnungskoeffizienten.

Wenn man davon ausgeht, daß die Cu-Scheiben 3, 4 bei der Ausdehnung nach Fig. 1 außerdem noch parallel zueinander bleiben sollen, so würden, wie in Fig. 5 gezeigt ist, durch die unterschiedliche radiale Dehnung f mit zunehmendem Abstand von der Mittellinie 6 erhebliche Zugspannungen an der Siliziumscheibe 1 angreifen und diese zerstören.

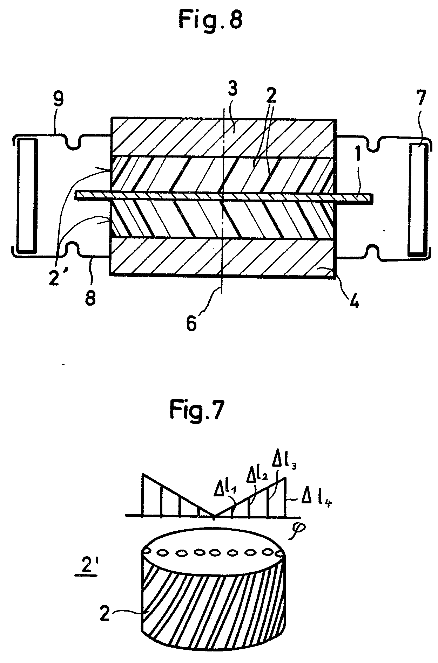

Gemäß den Fig. 7 und 8 wird daher den einzelnen Drähten 2 des Metallkontaktbündels 2' mit zunehmendem Abstand von der Mittellinie 6 eine bestimmte Längenvorgabe gegeben, z. B. dadurch, daß man das scheibenförmige Bündel 2' mit parallelen Scheibenoberflächen aus einem vorverdrillten Kabel parallel liegender Drähte herausschneidet.

Fig. 7 zeigt in übertriebener Darstellung eine Ansicht auf ein verdrilltes Bündel 2'. Darüber sind die Längenvorgaben $\Delta l_1, \Delta l_2 \ldots$ für die einzelnen Drähte 2 aufgetragen, die sich bei einem Verdrehwinkel $\varphi$ ergeben. Die relative Längung beträgt etwa 0,1% der jeweiligen ursprünglichen Länge.

In Fig. 8 ist am Beispiel einer Halbleiterperiode gezeigt, daß das mit der Wärmeleitscheibe 3 verlötete, in Ansicht dargestellte Bündel 2' entgegengesetzt verdrillt ist gegenüber dem mit der Wärmeableitscheibe 4 verlöteten Bündel 2'. Die Halbleiterdiode gemäß Fig. 8 besitzt ein den Rand der Siliziumscheibe 1 umlaufendes Keramikgehäuse 7 in üblicher Ausführung, das mit Metallringteilen 8, 9 für den axialen Längenausgleich, z. B. aus einer Nickel-Eisen-Legierung oder aus Kupfer oder aus Eisen, verlötet ist. Dieser Ringteil 8 bzw. 9 ist gleichzeitig mit dem Rand der zugehörigen Wärmeableitscheibe 3 bzw. 4 verlötet, so daß ein hermetischer Abschluß des Innenraumes des Halbleiterbauelementes entsteht.

Das in an sich bekannter Weise mit dem Gehäuse 7 versehene Leistungs-Halbleiterbauelement kann, da keine Druckkontaktierung mit Spannungsvorrichtung notwendig ist, in einfacher Weise mit Wärmerohren, luftgekühlten Kühlkörpern, flüssigkeitsgekühlten Kühldosen usw. gekühlt werden.

Es versteht sich, daß man auch zwei oder mehrere für sich gehäuselose Anordnungen aus Siliziumtablette 1, Metallbündelkontakten 2' und Wärmeableitscheiben 3 und 4 in ein gemeinsames Gehäuse zu einem Modul integrieren kann, wobei dann für potentialmäßig zu trennende Hauptelektroden eine elektrisch isolierte Wärmeabführung erfolgt.

Nachfolgend wird die Wirkungsweise der erfindungsgemäßen Kontaktierung bei ihrer Herstellung und bei Temperaturwechselbeanspruchung erläutert: Wird die Wärmeableitscheibe 3, 4 aus Kupfer über ein vorverdrilltes Bündel 2' mit der Siliziumscheibe 1 verlötet, so können beim Abkühlen des Sandwichs aus Siliziumscheibe 1 und Wärmeableitscheiben 3 und 4 die mit zunehmendem Abstand von der Mittellinie erforderlichen Längungen der einzelnen Drähte 2 aus dem Vorrat der durch die Verdrillung vorhandenen Längenvorgaben $\Delta l_1, \Delta l_2 \ldots$ entnommen werden, d. h. die vorher in das Bündel 2' eingebrachte Verdrillung wird durch die unterschiedliche Wärmedehnung je nach Vorgabe zum Teil wieder aufgehoben. Bezogen auf nur zwei Partner, nämich die Siliziumscheibe 1 und eine Wärmeleitscheibe 3, z. B. aus Kupfer, wird die unterschiedliche radiale Wärmeausdehnung zwischen Kupfer und Silizium auf eine weitgehend kräftefreie Drehbewegung zwischen der Kupferscheibe 3 und der Siliziumscheibe 1 zurückgeführt: Die in Fig. 5 dargestellten Zugspannungen entfallen weitgehend. Es bleiben lediglich die in Fig. 4 aufgetragenen Schubspannungen, die sich aber durch Reduktion der Drahtdurchmesser beliebig klein halten lassen. Der erforderliche Drehwinkel ergibt sich in erster Näherung aus

$$(6) \quad \varphi = \Delta\alpha \cdot \Delta T$$

Für die Kombination Cu—Si beträgt der Drehwinkel $\varphi$ etwa 3°.

Wenn man nun die andere Seite der Siliziumscheibe 1 ebenfalls mit einem Bündel 2' versieht, das im entgegengesetzten Drehsinn vorverdrillt ist, so können die beiden Wärmeableitscheiben 3 und 4 hinsichtlich einer gegenseitigen Verdrehung festgehalten werden. Radiale Ausdehnungsunterschiede zwischen den Wärmeableitscheiben 3 und 4 und der Siliziumscheibe 1 werden durch eine Drehung der Siliziumscheibe 1 um die Mittellinie 6 um etwa einen Winkel von 3° aufgefangen. Dies gilt auch für die betriebliche Temperaturwechselbeanspruchung.

Die Fig. 7 und 8 sind lediglich schematische Darstellungen mit weit auseinanderliegenden Drähten 2. Tatsächlich ist eine Packungsdichte möglichst weit über 50% für die Bündel 2' anzustreben, wobei die einzelnen Drähte 2 gegeneinander beweglich bleiben sollen. Die Beweglichkeit bringt mit der vorbeschriebenen Entlastung der Siliziumscheibe 1 von Zugspannungen den weiteren Vorteil der stabilen stoffschlüssigen Verbindung zur Siliziumscheibe 1 und der jeweiligen Wärmeableitscheibe 3, 4. Damit wird erreicht, daß eine Wärmeabfuhr im gesamten Flächenbereich erfolgt und die grundsätzliche Bedingung erfüllt wird, daß die Temperatur an keiner Stelle eine vorgegebene zulässige Grenze überschreitet. Die Gefahr bei der bekannten Druckkontakttechnik, daß die beteiligten Partner nur in Teilflächenbereichen kontaktiert sind, ist wesentlich vermindert. Die aufwendige Herstellung exakt planer Flächen oder nach einer vorgegebenen Funktion aneinander genau angepaßter Flächen kann entfallen.

Die Beweglichkeit kann z. B. durch eine Gleitschicht aus Kohlenstoff sichergestellt werden. Die Beschichtung mit Kohlenstoff wird in folgender Weise vorgenommen: Nitrocellulose wird mit Amylacetat vermischt. Mit dieser Mischung wird ein mit 2 Umdrehungen auf 1 m Länge verdrilltes Kabel beschichtet. Durch die Beschichtung sind die Drähte in ihrer Lage zueinander fixiert und können quer zur Kabelachse in die scheibenförmigen Metallbündelkontakte 2' zerschnitten werden. Der dann zwischen Wärmeableitscheibe 3 bzw. 4 und Siliziumscheibe 1 eingesetzte Metallbündelkontakt 2' wird auf etwa 520 K in Vakuum erhitzt. Amylacetat ist flüchtig; die Nitrocellulose wird in gasförmige Bestandteile und den auf den Drähten 2 verbleibenden Kohlenstoff zersetzt.

Weitere mögliche Stoffe für die Gleitschicht sind eloxiertes Aluminium und Emaille. Diese Stoffe verhindern wie Kohlenstoff ein Versintern der Drähte 2 untereinander und sind außerdem lotabweisend, so daß beim Anlöten der Drähte 2 an die Siliziumscheibe 1 einerseits und an die Wärmeableitscheibe 3, 4 andererseits kein Lot in die Drahtzwischenräume eindringen kann.

Eine weitere Möglichkeit besteht darin, die zu einem Bündel parallel zusammengefaßten Drähte 2 oder Unterbündel bzw. Litzen mit einer Silikonkautschuk-Einbettmasse mit geschlossenen Poren zu vergießen. Diese Einbettmasse besitzt die Eigenschaft, in kleinste Ritzen im µm-Bereich und somit in die Drahtzwischenräume einzudringen, und hat eine hohe Elastizität nach dem Vernetzen. Ihre Temperaturbeständigkeit liegt über 520 K. Sie ist wie die vorgenannten Stoffe lotabweisend. Es hat sich gezeigt, daß sogar jedes einzelne Drähtchen von z. B. 0,07 mm Durchmesser einer Litze mit einer Querschnittsfläche von 2,0 mm² allseitig von der Einbettmasse umschlossen wird.

Die Vorteile dieses Vorgehens bestehen in folgenden Punkten:

— von einem vergossenen Litzenpaket können scheibenförmige Metallbündel 2' sehr einfach abgetrennt werden;
— die einzelnen Drähte 2 jedes Metallbündels 2' sind gegeneinander völlig elastisch positioniert;
— die Zwischenräume zwischen den Drähten 2 werden bei der Bearbeitung und beim Löten frei von Verunreinigungen und von Lot gehalten.

Werden z. B. 137 Unterbündel (Litzen) von 2,0 mm² Querschnitt zu einem Bündel von 26 mm Ø zusammengefaßt und vergossen, so beträgt der Füllgrad bzw. die Packungsdichte ca. 60%. Der spezifische Wärmewiderstand $R_{th}$ eines 5 mm dicken Metallbündelkontaktes 2' beträgt $R_{th} = 0,25°C/W/cm^2$.

Wie bereits erwähnt, kann man allen Drähten 2, unabhängig von ihrem Abstand von der Mittelachse, eine Längenvorgabe mitgeben. Dies kann dadurch realisiert werden, daß man den Metallbündelkontakt 2' aus einer großen Anzahl zusammengefaßter vorverdrillter Unterbündel (z. B. Litzen von 2,0 mm² Querschnitt, Durchmesser der einzelnen Drähte 0,07 mm) aufbaut. Damit ist erreicht, daß jeder einzelne Draht 2 des Metallbündelkontaktes 2' eine wendeltreppenartige Form besitzt. Dies hat folgende Vorteile:

— unterschiedliche radiale Dehnungen der Siliziumscheiben 1 und der Wärmeableitscheibe 3 bzw. 4 können unabhängig vom Abstand von der Mittelachse aufgenommen werden, was z. B. — wie eingangs erläutert — bei einem von der Mitte nach außen abfallenden Temperaturprofil der einzelnen Scheiben wichtig ist;
— die Metallbündelscheibe 2' besitzt auch in axialer Richtung eine gegenüber der radialen geringe Elastizität, wodurch die Anforderungen an die Planheit der einzelnen Scheiben herabgesetzt werden können. Bei zu kontaktierenden Siliziumscheiben 1 von 50 bis 100 mm Durchmesser (ohne daß damit eine obere Grenze für die erfindungsgemäße Kontaktierungstechnik erreicht ist) führt dies zu einer erheblichen Kostenreduktion.

Zur Erzielung dieser beiden wesentlichen Vorteile kann in Kauf genommen werden, daß die erreichbare Packungsdichte (ca. 60%) unter derjenigen der in Zusammenhang mit Fig. 7 beschriebenen Bündel (ca. 90%) liegt. Gegenüber einer herkömmlichen Molybdän-Ronde wird in beiden Fällen eine um einen Faktor zwischen 1,5 und 2 höhere Leitfähigkeit des Metallbündelkontaktes 2' erreicht.

Das Abschneiden eines planparallelen Metallbündelkontaktes 2' von einem vorverdrillten Paralleldrahtkabel kann elektroerosiv erfolgen. Das Auseinanderfallen des Bündels 2' kann durch die Bindung durch den Schichtstoff und/oder durch eine nach dem Löten lösbare, äußere Manschette verhindert werden.

Die Lötverbindung zwischen Bündel 2' und Siliziumscheibe 1 kann mit einem herkömmlichen Gold- oder Silberlot erfolgen.

Eine weitere Möglichkeit besteht darin, die Siliziumscheibe 1 und die Scheibenoberfläche des Metallbündels 2' zu vergolden und beide unter Druck bei einer Temperatur von etwa 520 K miteinander zu verschweißen.

6

**0 013 707**

**Patentansprüche**

1. Leistungs-Halbleiterbauelement mit einem Gehäuse (7), in dem eine mindestens einen pn-Übergang aufweisende Halbleiterscheibe (1) über einen aus einem bürstenähnlichen Bündel (2') von verdrillten Einzeldrähten (2) bestehenden Metallkontakt mit einer Kupferscheibe (3; 4), die zur Wärmeableitung und zur Stromzuführung dient, stoffschlüssig verbunden ist, dadurch gekennzeichnet, daß jeder Einzeldraht (2) so mit einer Gleitschicht überzogen ist, daß die Einzeldrähte (2) sich untereinander nicht stoffschlüssig verbinden, daß die Einzeldrähte (2) mit zunehmendem Abstand von der Mittellinie des Bündels (2') zunehmend länger sind als es dem Abstand zwischen Halbleiterscheibe (1) und Kupferscheibe (3; 4) entspricht und daß jeder Einzeldraht (2) unmittelbar mit der Halbleiterscheibe (1) stoffschlüssig verbunden ist.

2. Leistungs-Halbleiterbauelement nach Anspruch 1, dadurch gekennzeichnet, daß die Verdrillung der Einzeldrähte (2) im Bündel (2') so gewählt ist, daß auf 1 m Länge des Bündels (2') zwei Umdrehungen kommen.

3. Leistungs-Halbleiterbauelement nach Anspruch 1 oder 2, dadurch gekennzeichnet, daß das Bündel (2') aus Unterbündeln besteht, die ebenfalls in sich vorverdrillt sind.

4. Leistungs-Halbleiterbauelement nach Anspruch 1, dadurch gekennzeichnet, daß die Gleitschicht aus Kohlenstoff besteht.

5. Leistungs-Halbleiterbauelement nach Anspruch 1, dadurch gekennzeichnet, daß die Gleitschicht aus eloxiertem Aluminium besteht.

6. Leistungs-Halbleiterbauelement nach Anspruch 1, dadurch gekennzeichnet, daß die Gleitschicht aus Emaille besteht.

7. Leistungs-Halbleiterbauelement nach wenigstens einem der Ansprüche 1 bis 6, dadurch gekennzeichnet, daß die Zwischenräume zwischen den Einzeldrähten (2) durch eine hochelastische Füllmasse in Schaumform ausgefüllt sind.

8. Leistungs-Halbleiterbauelement nach Anspruch 7, dadurch gekennzeichnet, daß die Füllmasse aus Silikonkautschuk besteht.

9. Leistungs-Halbleiterbauelement nach wenigstens einem der Ansprüche 1 bis 8, dadurch gekennzeichnet, daß die Halbleiterscheibe (1) beidseitig über je ein Bündel (2') mit je einer Kupferscheibe (3; 4) verbunden ist.

10. Leistungs-Halbleiterbauelement nach Anspruch 9, dadurch gekennzeichnet, daß die beiden Bündel (2') mit einander entgegengesetztem Drehsinn vorverdrillt sind.

**Claims**

1. A power semiconductor device with a casing (7), in which a semiconductor plate (1) having at least one p-n junction is connected by its material, by way of a metal contact consisting of a brush-like bundle (2') of twisted individual wires (2), to a copper plate (3; 4) which is used for heat removal and current supply, characterized in that each individual wire (2) is coated with a slip layer in such a way that the individual wires (2) are not connected to one another by their material, that the individual wires (2) are longer, to an extent that increases as the distance from the median line of the bundle (2') increases, than correspons to the distance between the semiconductor plate (1) and the copper plate (3; 4) and that each individual wire (2) is directly connected to the semiconductor plate (1) by its material.

2. A power semiconductor device according to Calim 1, characterized in that the twist of the individual wires (2) in the bundle (2') is selected such that two turns occur for every 1 metre in length of the bundle (2').

3. A power semiconductor device according to Claim 1 or 2, characterized in that the bundle (2') consists of subsidiary bundles which are likewise pre-twisted on themselves.

4. A power semiconductor device according to Claim 1, characterized in that the slip layer consists of carbon.

5. A power semiconductor device according to Claim 1, characterized in that the slip layer consists of anodized aluminium.

6. A power semiconductor device according to Claim 1, characterized in that the slip layer consists of enamel.

7. A power semiconductor device according to at least one of Claims 1 to 6, characterized in that the interspaces between the individual wires (2) are filled in by a highly resilient filling mass in the form of foam.

8. A power semiconductor device according to Claim 7, characterized in that the filling mass consists of silicone rubber.

9. A power semiconductor device according to at least one of Claims 1 to 8, characterized in that the semiconductor plate (1) is connected on both sides to a respective copper plate (3; 4) by way of a respective bundle (2').

7

10. A power semiconductor device according to Claim 9, characterized in that the two bundles (2') are pre-twisted in opposite directions of rotation.

## Revendications

1. Composant semi-conducteur de puissance comportant une enveloppe (7) dans laquelle un disque semi-conducteur (1) présentant au moins une jonction pn est relié de matière par l'intermédiaire d'un contact métallique constitué d'un faisceau ressemblant à une brosse (2') de fils individuels torsadés (2) et comportant un disque en cuivre (3; 4) qui sert à dériver la chaleur et à amener le courant, caractérisé en ce que chaque fil individuel (2) est revêtu d'une couche glissante de telle manière que les fils individuels (2) ne sont pas reliés de matière les uns aux autres, en ce que les fils individuels (2) sont de plus en plus longs que ce qui correspond à la distance entre le disque semi-conducteur (1) et le disque en cuivre (3; 4), à mesure qu'on s'éloigne du centre du faisceau (2') et en ce que chaque fil individuel (2) est relié de matière directement au disque semi-conducteur (1).

2. Composant semi-conducteur de puissance selon la revendication 1, caractérisé en ce que la torsade des fils individuels (2) du faisceau (2') est choisie de telle manière qu'il y a deux tours par mètre de longueur du faisceau (2').

3. Composant semi-conducteur de puissance selon la revendication 1 ou 2, caractérisé en ce que le faisceau (2') est constitué par des faisceaux secondaires qui sont également pré-torsadés en eux-mêmes.

4. Composant semi-conducteur de puissance selon la revendication 1, caractérisé en ce que la couche glissante est constituée par du carbone.

5. Composant semi-conducteur de puissance selon la revendication 1, caractérisé en ce que la couche glissante est constituée par de l'aluminium anodisé.

6. Composant semi-conducteur de puissance selon la revendication 1, caractérisé en ce que la couche glissante est constituée d'émail.

7. Composant semi-conducteur de puissance selon au moins l'une des revendications 1 à 6, caractérisé en ce que les espaces intermédiaires entre les fils individuels (2) sont remplis d'une matière de remplissage très élastique en forme de mousse.

8. Composant semi-conducteur de puissance selon la revendication 7, caractérisé en ce que la masse de remplissage est constituée par du caoutchouc siliconé.

9. Composant semi-conducteur de puissance selon au moins l'une des revendications 1 à 8, caractérisé en ce que le disque semi-conducteur (1) est relié des deux côtés par l'intermédiaire d'un faisceau respectif (2') ayant un disque de cuivre respectif (3; 4).

10. Composant semi-conducteur de puissance selon la revendication 9, caractérisé en ce que les deux faisceaux (2') sont pré-torsadés avec un sens de rotation mutuellement contraire.

Fig.1

Fig.2a

Fig.2b

Fig.6

9

# Fig . 3

$$\alpha_{Cu} = 175 \cdot 10^{-7} \; 1/K$$
$$\alpha_{Si} = 23 \cdot 10^{-7} \; 1/K$$

# Fig.4

# Fig.5

# Fig. 8

# Fig. 7